# EUROPEAN PATENT SPECIFICATION

(11) **EP 2 726 223 B1**
(45) Date of publication and mention of the grant of the patent: **10.06.2015**
(21) Application number: 12732828.4
(22) Date of filing: 29.06.2012
(51) Int. Cl.: C23C 16/44, B08B 9/08

(54) **CLEANING TOOL AND METHOD FOR A POLYSILICON REACTOR**
REINIGUNGSWERKZEUG UND VERFAHREN FÜR EINEN POLYSILIZIUMREAKTOR
OUTIL DE NETTOYAGE ET PROCÉDÉ POUR RÉACTEUR À SILICIUM POLYCRISTALLIN

(30) Priority: 29.06.2011 US 201161502614 P
(43) Date of publication of application: 07.05.2014
(73) Proprietor: MEMC Electronic Materials S.p.A., 28100 Novara (IT)
(72) Inventor: BOVIO, Ezio, I-28100 Novara (IT); MOLINO, Paolo, I-28100 Novara (IT); GAVA, Diego, I-28100 Novara (IT)
(74) Representative: Maiwald Patentanwalts GmbH
(86) International application number: PCT/EP2012/062720
(87) International publication number: WO 2013/001068

(56) References cited:
- EP-A1- 1 236 521
- EP-A1- 2 082 814

## Description

### FIELD

This disclosure generally relates to systems and methods for cleaning a polysilicon reactor and, more specifically, to a cleaning tool for cleaning an interior of a polysilicon reactor.

### BACKGROUND

Ultrapure polysilicon used in the electronic and solar industry is often produced through deposition from gaseous reactants via a chemical vapor deposition (CVD) process conducted within a reactor.

One process used to produce ultrapure polycrystalline silicon in a CVD reactor is referred to as a Siemens process. Silicon rods disposed within the reactor are used as seeds to start the process. Gaseous silicon-containing reactants flow through the reactor and deposit silicon onto the surface of the rods. The gaseous reactants (i.e., gaseous precursors) are silane-containing compounds such as halosilanes or monosilanes. The reactants are heated to temperatures above 1000°C and under these conditions decompose on the surface of the rods. Silicon is thus deposited on the rods according to the following overall reaction:

2 HSiCl₃ → Si + 2 HCl + SiCl₄.

The process is stopped after a layer of silicon having a predetermined thickness has been deposited on the surface of the rods. The rods 100 are then extracted from the CVD reactor and the silicon is harvested from the rods for further processing.

After the rods are extracted, the reactor is cleaned to remove silicon and other materials deposited on an interior surface of the reactor. In known systems, the reactor is typically cleaned manually by a technician. The technician cleans the reactor by spraying de-ionized water against the interior surface.

This Background section is intended to introduce the reader to various aspects of art that may be related to various aspects of the present disclosure, which are described and/or claimed below. This discussion is believed to be helpful in providing the reader with background information to facilitate a better understanding of the various aspects of the present disclosure. Accordingly, it should be understood that these statements are to be read in this light, and not as admissions of prior art.

EP 2 082 814 discloses a reactor cleaning apparatus which cleans an inner wall surface of a reactor which produces polycrystalline silicon.

### BRIEF SUMMARY

One aspect is a system for cleaning an interior surface of a chemical vapor deposition reactor bell. The system includes a fram disposed beneath the reactor bell and connected to a flange of the reactor bell, an actuating mechanism connected to the frame, the actuating mechanism configured for vertical and rotational movement within an interior space of the reactor bell when the reactor bell is connected to the frame, at least one brush connected to the actuating mechanism, the brush configured to contact the interior surface of the reactor bell, and at least one nozzle connected to the actuating mechanism, the nozzle configured to direct a flow of liquid against the interior surface of the reactor bell.

Another aspect is a method of cleaning an interior surface of a chemical vapor deposition reactor bell using a brush is provided. The method comprises positioning the reactor bell atop a frame, operating a first actuator such that the brush engages the interior surface of the reactor bell, directing a flow of liquid from a nozzle against the interior surface of the reactor bell, and operating a second actuator to rotate the brush.

Various refinements exist of the features noted in relation to the above-mentioned aspects. Further features may also be incorporated in the above-mentioned aspects as well. These refinements and additional features may exist individually or in any combination. For instance, various features discussed below in relation to any of the illustrated embodiments may be incorporated into any of the above-described aspects, alone or in any combination.

### BRIEF DESCRIPTION OF THE DRAWINGS

Figure 1 is a perspective view of a system for cleaning an interior surface of a chemical vapor deposition reactor;
Figure 2 is a front view of the system of Figure 1;
Figure 3 is a top view of the system of Figure 1;
Figure 4 is an enlarged view of a portion of the system of Figure 1 indicated by a dashed circle in Fig. 1;
Figure 5 is an enlarged view of a portion of the system of Figure 1 indicated by a dashed circle in Fig. 1; and
Figure 6 is an enlarged view of a portion of the system of Figure 1 indicated by a dashed circle in Fig. 1.

Like reference symbols in the various drawings indicate like elements.

### DETAILED DESCRIPTION

The embodiments described herein generally relate to systems and methods for cleaning an interior surface of a chemical vapor deposition (CVD) polysilicon reactor. The systems are operable to rinse the interior surface with a liquid and scrub the interior surface with brushes. The systems may also be operable to dry the interior surface with a flow of gas.

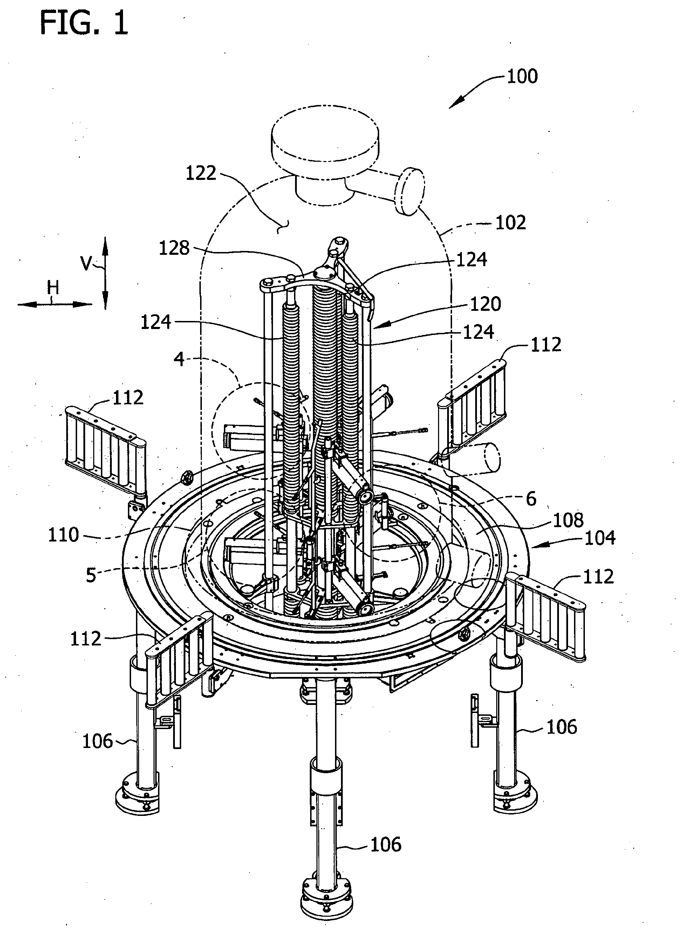

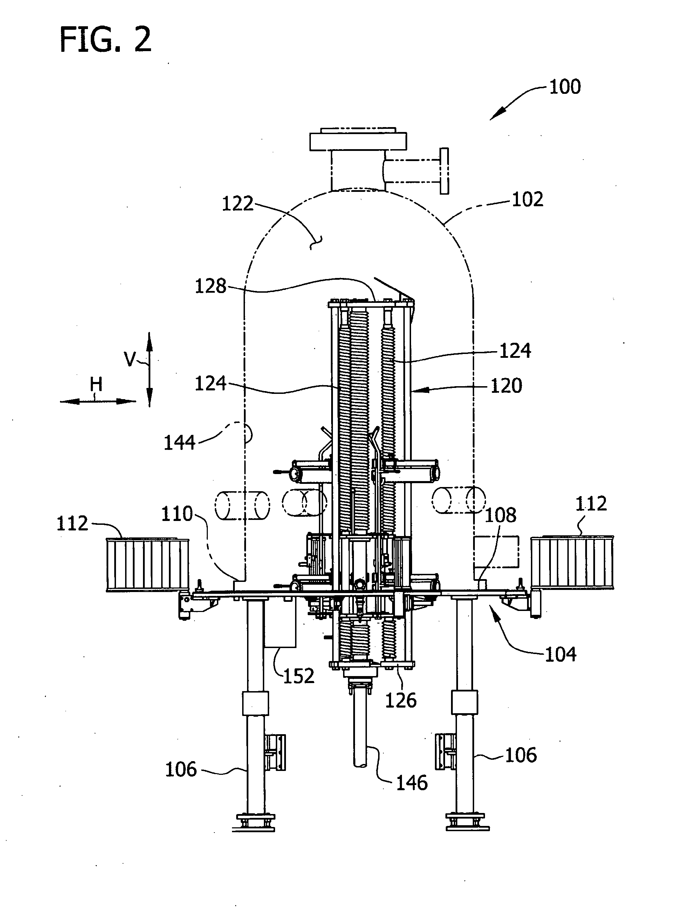

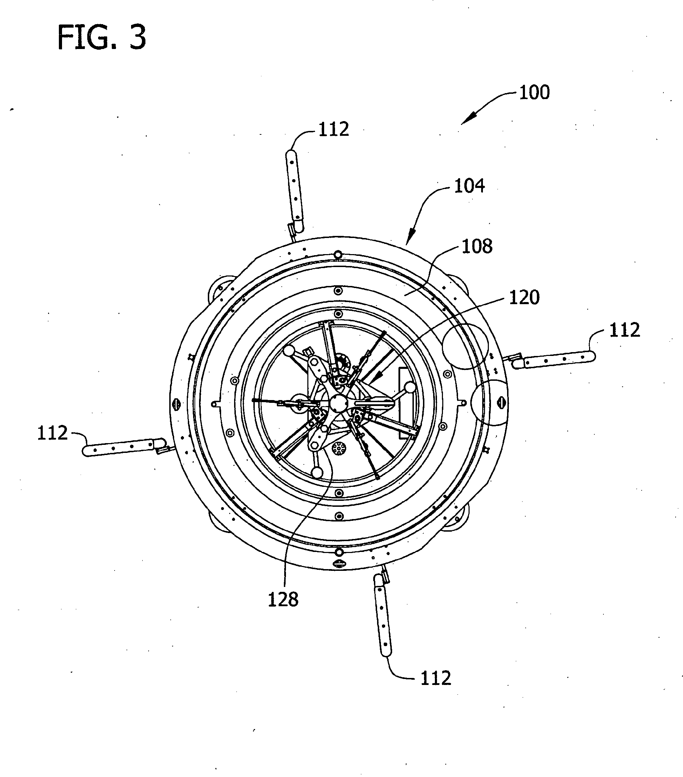

An exemplary system for cleaning an interior surface of a CVD reactor is indicated generally at 100 in Figures 1-6. During use, the system 100 is positioned within a reactor bell 102 (broadly, a housing) of the CVD reactor. The reactor bell 102 is shown in phantom in Figures 1 and 2. The system 100 may alternatively be substantially stationary and the bell may be lowered or positioned around the system by a hoist or other suitable structure.

The system comprises a frame 104 having four legs 106 in the example embodiment. A flange 108 for supporting the reactor bell 102 during use is connected to the frame 104 and is positioned generally adjacent to the legs 106. The flange 108 has a diameter that is the same as or larger than that of a bottom flange 110 of the reactor bell 102. As shown in Figure 2, the bottom flange 110 of the reactor bell 102 is disposed on the flange 108 during use of the system 100. The flange 108 may have openings formed therein to accommodate mechanical fasteners used to secure the bottom flange 110 of the reactor bell 102 to the flange. Moreover, clamps 112 attached to the frame 104 may be used to hold the bottom flange 110 of the reactor bell 102 in contact with the flange 108 of the frame 104. Four circumferentially spaced clamps 112 are used in the example embodiment, although different numbers or configurations of clamps can be used in other embodiments. Moreover, the clamps 112 are shown in an unsecured state in the Figures. To fasten the bottom flange 110 of the reactor bell to the flange 108, the clamps 112 are pivoted inward.

An articulating mechanism 120 is disposed in a central portion 122 of the system 100 and is connected to the frame. 104. The articulating mechanism 120 in the example embodiment has three separate actuators 124, although other embodiments may have a different number of actuators. Each of the actuators 124 is connected at one end to a base plate 126 that is in turn connected to the frame 104. At the other opposing end, the actuators 124 are connected to a top plate 128.

Two pairs of brushes 130 and nozzles 132 (described in greater detail below) are connected to each of the actuators 124. The actuators 124 are movable in a vertical direction parallel to a vertical axis V. Each actuator 124 may be moved independently of the others. The articulating mechanism 120 can be rotated by about an axis parallel to the V axis by rotation of the base plate 126 and/or top plate 128.

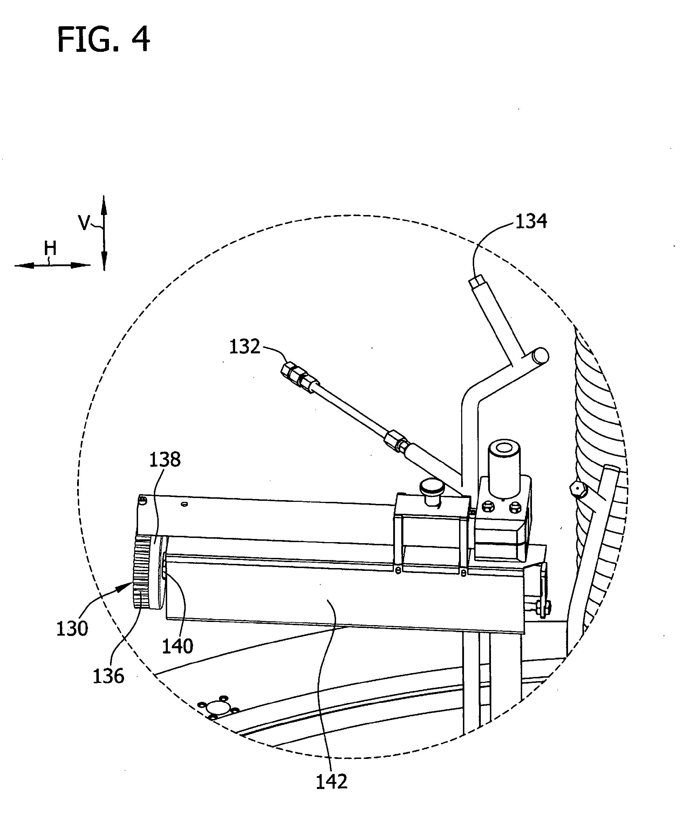

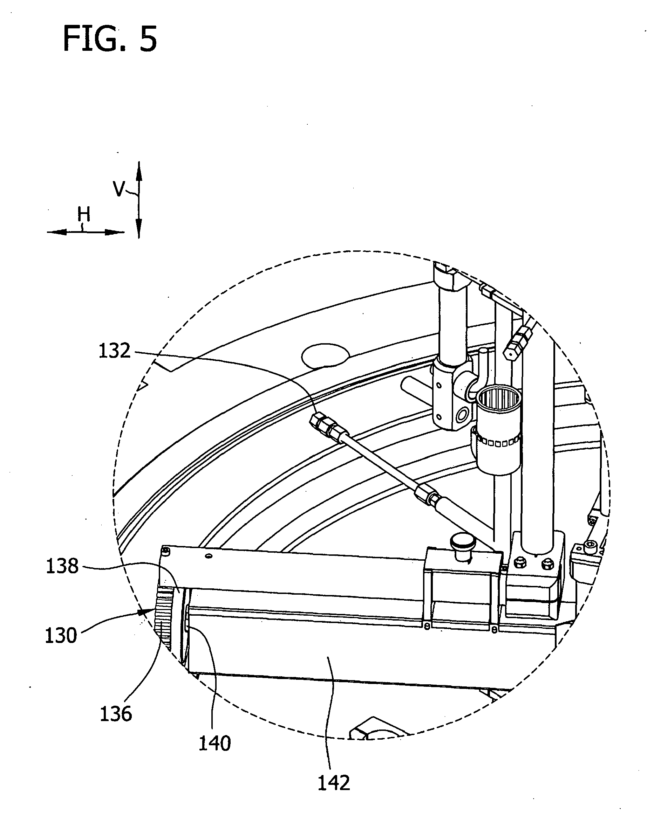

In the example embodiment as shown in Figures 4 and 5, each pair of brushes 130 and nozzles 132 is vertically spaced apart from the other. The nozzles 132 are also angularly displaced relative to the brushes 130. Moreover, an additional nozzle 134 (Figure 4) is positioned above each of the nozzles 132. There are thus nine nozzles 132, 134 and six brushes 130 in the example embodiment. Other embodiments may use a different number and/or arrangement of nozzles and brushes.

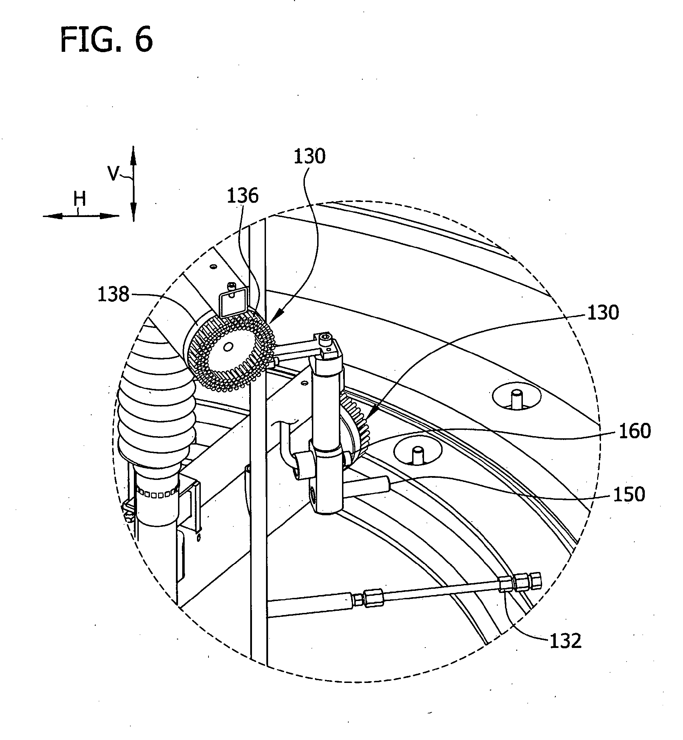

Each brush 130, one of which is shown in detail in Figure 6, has bristles 136 protruding from a circular-shaped head 138. The bristles 136 are disposed about a perimeter of the circular-shaped head 138 in the example embodiment, although in other embodiments they may be disposed in other portions of the head. The bristles 136 may be constructed from any suitable material, such as polyamide and fiber glass, polytetrafluoroethylene (PTFE) in combination with carbon and/or stainless steel. Moreover, some embodiments may use heads 138 that are shaped differently (e.g., rectangular, triangular, oblong, or square).

As shown in Figures 4 and 5, the brush 130 is connected to a suitable rotary actuator 140 that is operable to rotate the head 138 of the brush 130. According to one embodiment, the rotary actuator 140 is operable to rotate the brush 130 at a predetermined number of revolutions per minute (RPM). In the example embodiment, the brushes 130 rotate at approximately 200 to 300 RPMs, although other embodiments may rotate the actuator at different RPMs. Moreover, the actuator 140 may oscillate and/or vibrate the brush 130 in addition or instead of rotating the head 138.

The brush 130 is also connected to a suitable linear actuator 142 that is operable to laterally displace the brush 130 in a direction parallel to a horizontal axis H. In other embodiments, the linear actuator 142 may also be operable to displace the brush 130 in other directions that are not parallel to the horizontal axis H. The linear actuator 142 is capable of exerting sufficient force on the brush 130 to press the bristles 136 of the brush 130 against an interior surface 144 (Figure 2) of the reactor bell 102. This pressing of the brush 130 aids in removal of material (e.g., contaminants) disposed on the interior surface 144 of the reactor bell 102 by the bristles 136.

As referenced above, one of the nozzles 132 is positioned adjacent each brush 130 in the example embodiment. The additional nozzle 134 is positioned vertically above the uppermost pair of brushes 130 and nozzles 132. The nozzles 132, 134 are each connected to the articulating mechanism 120, although in other embodiments the nozzles 132, 134 may be connected to other structures within the system 100. In the example embodiment, there are an equal number of nozzles 132 and brushes 130. In other embodiments, there may be more or less nozzles 132' than brushes 130. Moreover, the nozzles 132 may be positioned differently such that they are not adjacent the brushes 130.

The nozzles 132, 134 are connected to a suitable fluid supply source 146 (a portion of which is shown in Figure 2) capable of supplying fluid (e.g., de-ionized water, detergent, water, etc.) to the nozzles. The nozzles 132, 134 are used to direct (e.g., spray) fluid against the interior surface 144 of the reactor bell 102. This fluid may be used to rinse the interior surface 144 after the surface has been scrubbed by the bristles 136 of the head 138. This fluid (or another type of fluid) may also be directed (e.g., sprayed) .against the interior surface 144 while the bristles 136 of the head 138 are used to scrub the interior surface 144 of the reactor bell 102. For example, a detergent fluid may be used during the scrubbing of the interior surface 144 of the reactor bell 102. In some embodiments, the nozzles 132, 134 may be used to direct a flow of gas against the interior surface 144 of the reactor bell 102. This gas flow from the nozzles 132, 134 may be used to dry the interior surface 144 after the surface has been cleaned.

In the example embodiment, a drying nozzle 150 (Figure 6) is provided for directing a flow of gas against the interior surface 144 of the reactor bell 102. The gas is nitrogen in the example embodiment, although in other embodiments a different gas may be used (e.g., an inert gas). The drying nozzle 150 is connected to a portion of the articulating mechanism 120 (e.g., another actuator) that is operable to move the nozzle 150 to direct gas against different portions of the interior surface 144 of the reactor bell 102. Moreover, the drying nozzle 150 is connected to a suitable supply of gas (not shown). In the example embodiment, the drying nozzle 150 is used to direct a flow of gas against a viewing window (not shown) formed in the reactor bell 102. However, in other embodiments the drying nozzle 150 may be used to direct a flow of gas against other portions of or the entire interior surface 144 of the reactor bell 102. Moreover, the example embodiment includes a blower 152 positioned vertically beneath the flange 108 of the frame 104 to direct a flow of air or other suitable gas against the interior surface 144 of the reactor bell 102. This flow of air aids in drying the interior surface 144 after completion of a cleaning cycle. The example embodiment also includes a light 160 (Figure 6) to aid in inspection of the viewing window. The light 160 is a fiber optic light in the example embodiment that is connected to a suitable light generator (not shown). The light 160 also permits inspection of the interior surface 144 of the reactor bell 102 during the cleaning cycle described in greater detail below. While one light 160 is shown in Figure 6, multiple lights may be used and positioned throughout the system 100.

In use, a cleaning cycle begins when the reactor bell 102 is lowered or placed over the frame 104. The reactor bell 102 is then secured to the frame 104 with clamps 112 and/or suitable fasteners. The linear actuators 142 connected to the brushes 130 are then extended to bring the brushes into contact with the inner surface 144 of the reactor bell 102. Fluid is then sprayed from the nozzles 132, 134 against the interior surface 144 and the rotary actuators 140 begin to rotate the brushes 130. The rotation of the brushes 130 and the contact of the bristles 136 against the interior surface 144 remove deposited contaminants and/or debris from the interior surface. In other embodiments, the order of these initial steps may be altered. For example, the nozzles 132, 134 may spray fluid onto the interior surface 144 before the linear actuators are extended 142 and/or the brushes 130 are rotated by the rotary actuators 140.

As the brushes 130 rotate and the nozzles 132, 134 spray fluid, the articulating mechanism 120 moves the nozzles and brushes in a direction generally parallel to the vertical axis V. The articulating mechanism 120 also rotates the nozzles 132, 134 and brushes 130 about the vertical axis V. The rate of rotation and vertical movement of the articulating mechanism 120 may be adjusted in order to suitably remove debris and/or contaminants from the interior surface 144 of the reactor bell 102. Moreover, the rate of rotation and vertical movement may be adjusted based on the amount of contamination of the interior surface 144. A measurement of the amount of contamination may be made by an operator or with one or more sensors. The measurement may be taken at one or more points on the interior surface 144. A control system then adjusts the rate of rotation and vertical movement of the articulating mechanism 120 based on this measurement. In other embodiments, an operator may adjust the rate of rotation and vertical movement of the articulating mechanism 120 based on the measurement.

Furthermore, the articulating mechanism 120 may alter its rate of vertical movement and/or rotation of the brushes 130 and nozzles 132, 134 during cleaning of the interior surface 144 of the reactor bell 102. For example, the rate of vertical movement and/or rotation may be decreased when cleaning portions of the interior surface 144 that have greater amounts of contaminants deposited thereon than other portions of the interior surface. The rates may also be decreased when cleaning portions of the interior surface 144 that have lesser amounts of contaminants deposited thereon.

The cleaning cycle continues until the contaminants, or some portion or percentage thereof, are removed from the interior surface 144 of the reactor bell 102. In operation, another measurement may be taken to determine if the amount of contamination on the interior surface 144, or some portion or percentage thereof, have been removed from the interior surface. In other embodiments, the cleaning cycle may continue for a predetermined period of time (e.g., 30 minutes).

After the cleaning cycle is complete, the drying nozzle 150 is moved by the articulating mechanism 120 to a position adjacent the viewing window of the reactor bell 102. A flow of gas (e.g., nitrogen) is then directed by the drying nozzle 150 against the viewing window to dry the window and remove liquid from the surface of the window. The blower 152 may then be used to direct a flow of air against the interior surface 144 of the reactor bell 102 to dry the surface. In the example embodiment, the blower 152 is operable to heat the air to further aid in drying the interior surface 144.

After the interior surface 144 is dried, the clamps 112 and/or mechanical fasteners securing the reactor bell 102 to the frame 104 of the system 100 are removed. A hoist or other mechanism is then used to remove the reactor bell 102 from the frame 104. The reactor bell 102 is then either placed in service or stored for later use.

The cleaned reactor bell will have increased reflectivity. This increased reflectivity will reduce the energy consumed in the process and thereby make the process more efficient.

When introducing elements of the present invention or the embodiment(s) thereof, the articles "a", "an", "the" and "said" are intended to mean that there are one or more of the elements. The terms "comprising", "including" and "having" are intended to be inclusive and mean that there may be additional elements other than the listed elements. The use of terms indicating a particular orientation (e.g., "top", "bottom", "side", etc.) is for convenience of description and does not require any particular orientation of the item described.

## Claims

1. A system (100) for cleaning an interior surface of a chemical vapor deposition reactor bell (102), the system comprising:
a frame (104) disposed beneath the reactor bell and connected to a flange (108) of the reactor bell;
an actuating mechanism connected to the frame, the actuating mechanism configured for vertical and rotational movement within an interior space of the reactor bell when the reactor bell is connected to the frame;
at least one brush (130) connected to the actuating mechanism, the brush configured to contact the interior surface (144) of the reactor bell; and
at least one nozzle (132) connected to the actuating mechanism, the nozzle configured to direct a flow of liquid against the interior surface of the reactor bell.

2. The system of claim 1 further comprising a rotary actuator (140) connected to the at least one brush, the rotary actuator configured to rotate the brush.

3. The system of claim 1 further comprising a linear actuator (142) connecting the at least one brush to the actuating mechanism.

4. The system of claim 1 further comprising a drying nozzle (150) for directing a flow of gas against an interior surface of a window formed in the reactor bell.

5. The system of claim 4 further comprising a light (160) to aid in inspection of the window.

6. A method of cleaning an interior surface (144) of a chemical vapor deposition reactor bell (102) using a brush (130), the method comprising:
positioning the reactor bell (102) atop a frame (104);
operating a first actuators (142) such that the brush engages the interior surface of the reactor bell;
directing a flow of liquid from a nozzle (132) against the interior surface of the reactor bell; and
operating a second actuator (140) to rotate the brush.

7. The method of claim 6 further, comprising rotating the actuating mechanism about a vertical axis parallel to a longitudinal axis of the reactor bell.

8. The method of claim 7 further comprising moving the actuating mechanism along a vertical axis parallel to a longitudinal axis of the reactor bell.

9. The method of claim 8 further comprising measuring an amount of contamination of the interior surface.

10. The method of claim 9 further comprising adjusting a rate of rotation and vertical movement based on an amount of contamination of the interior surface.

11. The method of claim 6 further comprising directing a flow of gas against an interior surface of a window formed in the reactor bell.

## Patentansprüche

1. Ein System (100) zur Reinigung einer inneren Oberfläche einer Reaktorglocke (102) zur chemischen Dampfabscheidung, wobei das System umfasst:
einen Rahmen (104), der sich unterhalb der Reaktorglocke befindet und mit einem Flansch (108) der Reaktorglocke verbunden ist;
einen Antriebsmechanismus, der mit dem Rahmen verbunden ist, wobei der Antriebsmechanismus ausgelegt ist für eine vertikale Rotationsbewegung innerhalb eines Innenraums der Reaktorglocke, wenn die Reaktorglocke mit dem Rahmen verbunden ist;
wenigstens eine Bürste (130), die mit dem Antriebsmechanismus verbunden ist, wobei die Bürste so ausgelegt ist, dass sie die innere Oberfläche (144) der Reaktorglocke beführt; und
wenigstens eine Düse (132), die mit dem Antriebsmechanismus verbunden ist, wobei die Düse so konfiguriert ist, dass sie einen Flüssigkeitsstrom gegen die innere Oberfläche der Reaktorglocke lenkt.

2. Das System gemäß Anspruch 1, des weiteren umfassend ein Antriebselement zur Rotation (140), das mit der wenigstens einen Bürste verbunden ist, wobei das Antriebselement zur Rotation so konfiguriert ist, dass es die Bürste rotieren lässt.

3. Das System gemäß Anspruch 1, des weiteren umfassend ein Antriebselement für einen linearen Antrieb (142), welches die wenigstens eine Bürste mit dem Antriebsmechanismus verbindet.

4. Das System gemäß Anspruch 1, des weiteren umfassend eine Trackendüse (150) zur Leitung eines Gasstroms gegen eine innere Oberfläche eines Fensters, das sich in der Reaktorglocke befindet.

5. Das System gemäß Anspruch 4, des weiteren umfassend ein Licht (160), um eine Inspektion des Fensters zu unterstützten.

6. Ein Verfahren zur Reinigung einer inneren Oberfläche (144) einer Reaktorglocke (102) zur chemischen Dampfabscheidung unter Verwendung einer Bürste (130), wobei das Verfahren umfasst:
Positionierung der Reaktorglocke (102) oben auf einem Rahmen (104);
Bedienung eines ersten Antriebselements (142), so dass die Bürste die innere Oberfläche der Reaktorglocke beführt;
Dirigieren eines Flüssigkeitsstroms aus einer Düse (132) gegen die innere Oberfläche der Reaktorglocke; und
Bedienung eines zweiten Antriebselements (140), um die Bürste rotieren zu lassen.

7. Das Verfahren gemäß Anspruch 6, des weiteren umfassend das Rotieren des Antriebsmechanismus um eine vertikale Achse zu einer Längsachse der Reaktorglocke.

8. Das Verfahren gemäß Anspruch 7, des weiteren umfassend das Bewegen des Antriebsmechanismus entlang einer vertikalen Achse parallel zu einer Längsachse der Reaktorglocke.

9. Das Verfahren gemäß Anspruch 8, des weiteren umfassend die Messung einer Kontaminationsmenge auf der inneren Oberfläche.

10. Das Verfahren gemäß Anspruch 9, des weiteren umfassend die Anpassung der Rotationsrate und der vertikalen Bewegung, basierend auf der Kontaminationsmenge auf der inneren Oberfläche.

11. Das Verfahren gemäß Anspruch 6, des weiteren umfassend das Dirigieren eines Gasstroms gegen eine innere Oberfläche eines Fensters, das sich in der Reaktorglocke befindet.

## Revendications

1. Système (100) destiné à nettoyer une surface intérieure d'une cloche de réacteur de dépôt chimique en phase vapeur (102), le système comportant :
un bâti (104) disposé sous la cloche de réacteur et relié à une bride (108) de la cloche de réacteur,
un mécanisme d'actionnement relié au bâti, le mécanisme d'actionnement étant configuré pour un mouvement vertical et rotatif dans un espace intérieur de la cloche de réacteur lorsque la cloche de réacteur est reliée au bâti,
au moins une brosse (130) reliée au mécanisme d'actionnement, la brosse étant configurée pour venir en contact avec la surface intérieure (144) de la cloche de réacteur, et
au moins une buse (132) reliée au mécanisme d'actionnement, la buse étant configurée pour diriger un écoulement de liquide contre la surface intérieure de la cloche de réacteur.

2. Système selon la revendication 1, comportant en outre un actionneur rotatif (140) relié à ladite au moins une brosse, l'actionneur rotatif étant configuré pour faire tourner la brosse.

3. Système selon la revendication 1, comportant en outre un actionneur linéaire (142) reliant la au moins une brosse au mécanisme d'actionnement.

4. Système selon la revendication 1, comportant en outre une buse de séchage (150) pour diriger un écoulement de gaz contre une surface intérieure d'une fenêtre formée dans la cloche de réacteur.

5. Système selon la revendication 4, comportant en outre une lumière (160) pour aider à l'inspection de la fenêtre.

6. Procédé de nettoyage d'une surface intérieure (144) d'une cloche de réacteur de dépôt chimique en phase vapeur (102) utilisant une brosse (130), le procédé comportant les étapes consistant à :
positionner la cloche de réacteur (102) au-dessus d'un bâti (104),
faire fonctionner un premier actionneur (142) de telle sorte que la brosse vient en contact avec la surface intérieure de la cloche de réacteur,
diriger un écoulement de liquide à partir d'une buse (132) contre la surface intérieure de la cloche de réacteur, et
faire fonctionner un second actionneur (140) pour faire tourner la brosse.

7. Procédé selon la revendication 6, comportant en outre la rotation du mécanisme d'actionnement autour d'un axe vertical parallèlement à un axe longitudinal de la cloche de réacteur.

8. Procédé selon la revendication 7, comportant en outre le déglacement du mécanisme d'actionnement le long d'un axe vertical parallèlement à un axe longitudinal de la cloche de réacteur.

9. Procédé selon la revendication 8, comportant en outre la mesure d'une quantité de contamination de la surface intérieure.

10. Procédé selon la revendication 9, comportant en outre le réglage d'une vitesse de rotation et d'un mouvement vertical sur la base d'une quantité de contamination de la surface intérieure.

11. Procédé selon la revendication 6, comportant en outre l'étape consistant à diriger un écoulement de gaz contre une surface intérieure d'une fenêtre formée dans la cloche de réacteur.
